# EUROPEAN PATENT SPECIFICATION

(11) **EP 3 927 129 B1**
(45) Date of publication and mention of the grant of the patent: **07.06.2023**
(21) Application number: 20180560.3
(22) Date of filing: 17.06.2020
(51) Int. Cl.: H05K 9/00

(54) **A SYSTEM AND METHOD FOR PROTECTING CABINETS FROM EMI**
SYSTEM UND VERFAHREN ZUM SCHUTZ VON SCHRÄNKEN VOR EMV
SYSTÈME ET PROCÉDÉ PERMETTANT DE PROTÉGER LES ARMOIRES CONTRE LES INTERFÉRENCES ÉLECTROMAGNÉTIQUES

(43) Date of publication of application: 22.12.2021
(73) Proprietor: Primozone Production AB, 246 42 Löddeköpinge (SE)
(72) Inventor: Stoltz, Fredrik, S-246 42 Löddeköpinge (SE); van der Schaaf, Joakim, S-246 42 Löddeköpinge (SE)
(74) Representative: Plougmann Vingtoft a/s

(56) References cited:
- KR-A- 20160 039 327
- KR-A- 20160 076 413

## Description

### FIELD OF THE INVENTION

The present invention relates to a grounding method and system for providing grounding and electromagnetic shielding to a cabinet configured for containing an ozone generator.

### BACKGROUND OF THE INVENTION

Electromagnetic radiations can affect many sensitive electronics and can cause a wide variety of different issues from a simple hiss on a communication line, to a total disruption of a safety-critical signal. As such, electromagnetic radiations affect a diverse range of sectors, including all consumer and industrial electronics. In general, the main purpose of effective electromagnetic shielding is to prevent electromagnetic interference (EMI) from influencing sensitive electronics.

In cabinets, effective electromagnetic shielding is achieved through the grounding of the hatch or door. As today, two standard solutions are commonly used: knitted metal wire strip or bendable fingers.

Knitted metal wire strip, where the outer surface consists of a metal mesh net, ensures large surface area of contact between the hatch and the cabinet. Bendable fingers are often made of heat treated metal, such as copper, coated with other metals for optimal contact and low resistance, thus ensuring optimal grounding.

Other solutions comprise shielding gaskets for cabinets employing different combination of spring clips, spring fingers or lips creating contact between the opportune surfaces, mostly by applying appropriate pressure upon interference fit between complementary opposite members.

Generally, large surface area of contact are necessary, between the hatch and the enclosure of cabinets suitable for containing ozone generators, to ensure good grounding. KR 2016 0076413 A and KR 2016 0039327 A are known examples from the art.

However, very often current solutions do not allow for compliance with Electromagnetic compatibility (EMC) directive limits in electromagnetic emissions.

In addition, it appears very difficult to provide systems and methods that compensate for possible positioning faults, which lead to poor grounding.

Hence, an improved method and system for electromagnetic shielding of a cabinet for containing ozone generators would be advantageous, and in particular a more efficient and reliable method and system, for grounding an hatch to an enclosure of a cabinet for ozone generators, which ensure for compensation of a great deal of positioning faults, would be advantageous.

### OBJECT OF THE INVENTION

An object of the present invention is to provide an efficient grounding system for shielding a cabinet for ozone generator from EMI.

A further object of the present invention is to provide a cabinet for containing an ozone generator apparatus comprising a grounding system for providing earth connection and for shielding the ozone generator apparatus from interferences from electromagnetic radiations.

Another object of the present invention is to provide a cabinet containing an ozone generator apparatus and a method compensating for possible positioning faults, thus leading to an improved grounding and shielding from interferences generated by electromagnetic radiations.

An object of the present invention may also be seen as to provide an alternative to the prior art.

In particular, it may be seen as an object of the present invention to provide an efficient and reliable grounding and shielding system for providing earth connection to and for shielding from EMI an ozone generator apparatus, which solves the above mentioned problems of the prior art.

### SUMMARY OF THE INVENTION

The invention is defined by the features of independent claims 1 and 8. Further embodiments are defined in the dependent claims.

The above described objects and several other objects are intended to be obtained in a first aspect of the invention by providing a cabinet for an ozone generator, the cabinet comprising: an enclosure for containing an ozone generator; a hatch for delimiting the enclosure; one or more grounding means for providing earth connection between the enclosure and the hatch.

The grounding means for providing earth connection between the enclosure and the hatch are means for providing ground or earth connection, thus allowing for reduction of interference from electromagnetic radiations.

The cabinet of the invention is an ozone generator cabinet, i.e. it is a cabinet suitable for containing an ozone generator.

In some embodiments, the enclosure of the cabinet of the invention contains the ozone generator.

The cabinet is therefore referred to as ozone generator cabinet within the text.

The hatch, such as a door, is a means for delimiting or closing the enclosure.

In some embodiments, the grounding means comprises at least: an elastic system fasten to the enclosure; an elongated element having a first end and a second opposite end; the first end being fasten to the hatch, such as to an internal surface of the hatch, the second end adapted or configured to interfere with the elastic system.

An elastic system is a system having the ability of resisting to a distorting influence and to return to its original size and shape when that influence or force is removed.

In some embodiments, the elastic system is fasten to the internal surface of the enclosure.

The hatch may have an internal and external surface.

In some embodiments, the internal surface of the hatch is the surface facing the ozone generator contained in the cabinet when the hatch is closed.

The first end may be fasten to an internal surface of the hatch.

The elongated element may be an element extending out of the internal surface towards the opening of the enclosure, i.e. an element extending out in a direction normal to the internal surface of the hatch.

The second end of the elongated element is adapted or configured to interfere with the elastic system, such as by pressing one surface in contact with the elastic system.

In some embodiments, the elongated element is an elongated cylindrical body, such as a metal pin.

The enclosure comprises walls surrounding the ozone generator and at least one opening.

The hatch provides access to the ozone generator located inside the enclosure through the opening.

The enclosure is a container or a holder suitable for containing an ozone generator. The enclosure or container surrounds the ozone generator and have an opening to access the ozone generator, which is delimited by the presence of a hatch or door.

According to the invention, the elastic system is fasten to at least two of the walls surrounding the ozone generator.

The elastic system may be fasten to an edge of the at least two walls of said enclosure, i.e. in between two orthogonal walls.

In some further embodiments, the elastic system comprises at least an elastic element suspended in a holding element.

The elastic element comprises a metal helical coil spring, and wherein the holding element may be or comprise a spring bracket holding the spring.

The holding element has the function of holding the elastic element.

The elastic system may be a spring system.

The spring system may comprise an elongated element, a spring and a spring holder element or bracket, wherein the spring holder element has the function of fastening and keeping the spring in tension.

The spring is a helical or coil spring, such as a compression spring.

A compression spring is defined as a spiral of wire that returns to its original shape after compression.

In some embodiments, the spring holder may be fasten to two normal walls thus allowing for suspension of the spring at one corner of the enclosure.

In some embodiments, the second end of the elongated element is adapted or configured to interfere with the elastic element in a direction substantially orthogonal to a spring axis, wherein the spring axis is the spring compression or wind axis.

The spring has two main axis: the compression axis, i.e. the axis along which compression occurs and the lateral or side axis, being the two axis orthogonal to each other.

The second end of the elongated element is adapted or configured to interfere, when the hatch is closing, with the elastic element, so that the surface of the second end gets in contact with surfaces of the elastic element, or compression spring, in a direction along the lateral axis of the compression spring.

Upon closure of the hatch, the second end of the elongated element gets in contact with the elastic element, in a direction along its lateral axis, producing deformation of the elastic element and contact between the surface of the second end of the elongated element and surfaces of the elastic element.

At the opening of the hatch, the contact is removed and the elastic element returns to its initial shape and size.

In some embodiments, the second end of the elongated element may engage with the elastic element.

In some other embodiments, the one or more grounding means are at least two grounding means located not more than 0.5 m in between each other.

The grounding means may be more than one and may be located in different positions within the enclosure and the hatch.

As a preferred layout, the positioning of the grounding means, in order to gain a EMI reduction complying with EMC directive limits in electromagnetic emissions, has be at a distance not larger than 0.5 m in between each other, such as less than 0.5, for example less than 0.4 m, such as less than 0.3 m.

The advantage of the use of the current invention derives by the specific interaction between the elongated element in a perpendicular direction with the elastic element, which is able to absorb a great deal of positing faults.

Even if not perfectly aligned, the interference between the second end of the elongated element and the elastic element, such as a compression spring, along a direction orthogonal to the spring compression axis, allows for sufficient points of contacts thus providing sufficient EMI shielding.

The layout of the one or more grounding means, according to the invention compensate for a great deal of positioning faults, as the elastic element or spring bends either way, upon closure of the hatch, in case the elongated element is positioned slightly to the right or the left on the elastic element.

The invention allows for optimal grounding properties employing small contact points generating high contact pressure between the elongated element and the elastic system.

The movement of the elastic element or spring against the elongated element and within its holder or bracket mechanically removes eventual oxide layers formed on the connecting parts, thus ensuring good electrical contact.

In a second aspect, the invention relates to an ozone generator apparatus comprising the cabinet according to the first aspect of the invention.

In a third aspect, the invention relates to a method for providing grounding and electromagnetic shielding to a cabinet containing an ozone generator according to the first aspect of the invention, the method comprising: closing the hatch, thereby allowing for the elongated element to interfere with the elastic system.

The first, second, third and other aspects and embodiments of the present invention may each be combined with any of the other aspects and embodiments. These and other aspects of the invention will be apparent from and elucidated with reference to the embodiments described hereinafter.

### BRIEF DESCRIPTION OF THE FIGURES

The cabinet for an ozone generator, the ozone generator apparatus and the method for providing grounding and electromagnetic shielding to the cabinet according to the invention will now be described in more details with regard to the accompanying figures. The figures show one way of implementing the present invention and are not to be construed as being limiting to other possible embodiments falling within the scope of the attached claim set.
Figure 1A shows a graphical illustration of the cabinet for an ozone generator according to some embodiments of the invention.
Figure 1B is an enlarged partial view of the cabinet focusing on the means for grounding according to some embodiments of the invention.
Figure 2A and figure 2B are further enlarged partial view of the cabinet focusing on the means for grounding according to some embodiments of the invention while closing the hatch.
Figures 3, 4 and 5 show graphical illustrations of the elements of the means for grounding according to some embodiments of the invention.

### DETAILED DESCRIPTION OF AN EMBODIMENT

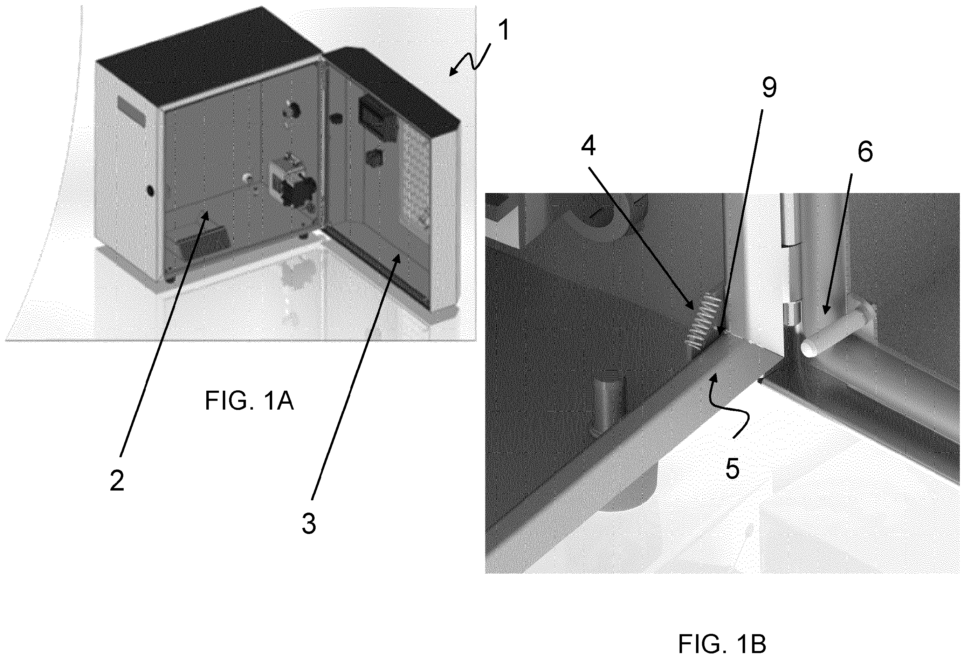

Figure 1A shows a graphical illustration of the cabinet 1 for an ozone generator according to some embodiments of the invention.

The cabinet 1 consists of an enclosure or container 2 in which the ozone generator (not shown) is contained and a hatch or door 3 that delimits the container and provides closure for the cabinet.

The one or more grounding means providing earth connection between the enclosure 2 and the hatch 3 are shown in figure 1B as the elastic system 5 comprising a spring 4 supported on a spring bracket 9 and a pin 6, according to some embodiments of the invention.

The spring bracket 9 is fasten inside the enclosure 2 at one corner.

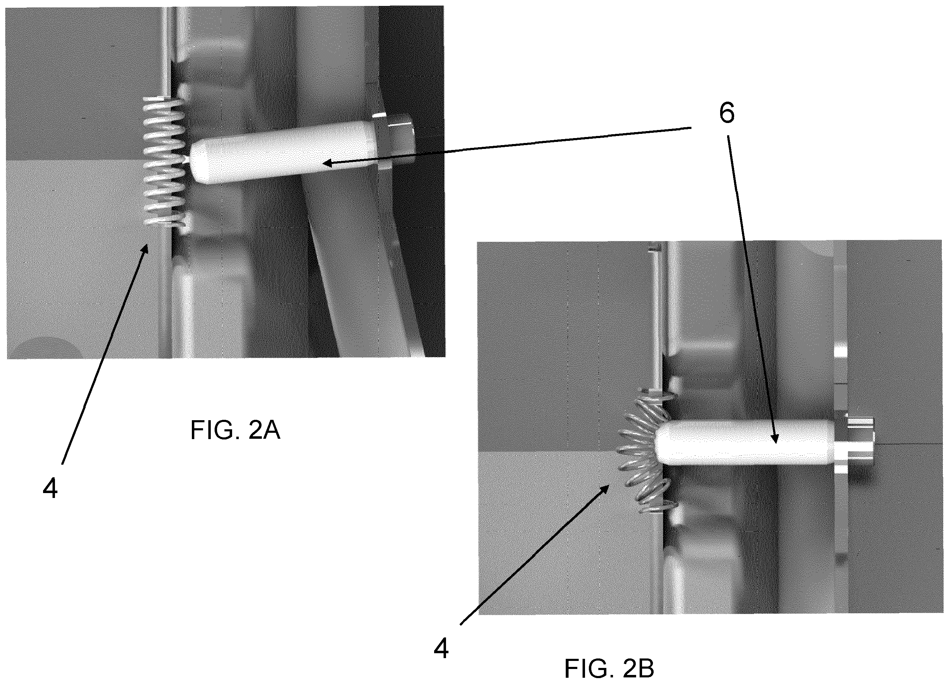

The closure of the hatch 3 generates a ground connection as the pin 6 interferes with the spring 4 located on the spring bracket 9 as shown in figure 2A and figure 2B.

As clearly seen in figures 2A and 2B, the pin 6 interferes with the spring 4 in a perpendicular direction to the compression axis of the spring 4.

The flexibility of spring 4 allows for a great deal of positing faults, so that even if pin 6 and spring 4 are not perfectly aligned, the points of contacts between the two elements provide sufficient EMI shielding so as to comply with EMC directive limits.

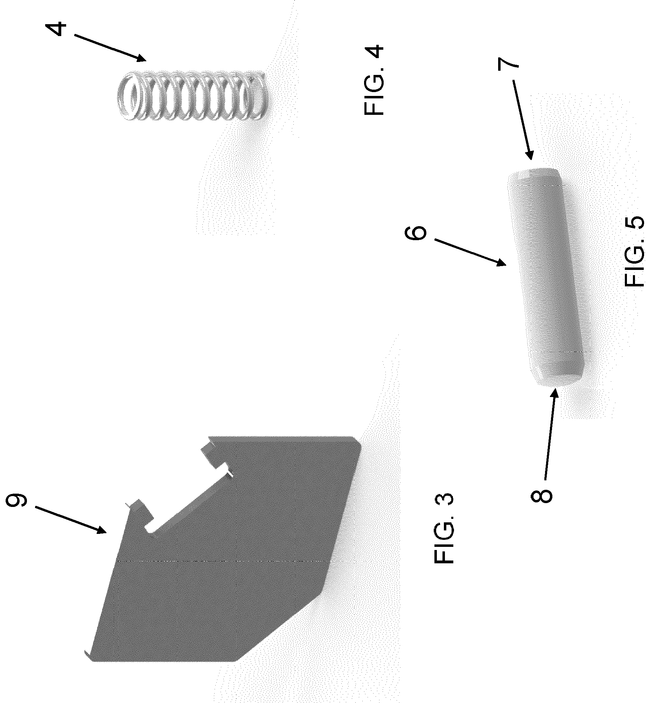

Figures 3, 4 and 5 show a graphical illustration of the spring bracket 9, the spring 4 and the pin 6 having a first end 7 fasten to the hatch and a second end 8 configured to interfere with the spring 4 supported by the spring bracket 9 according to some embodiments of the invention.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. In addition, the mentioning of references such as "a" or "an" etc. should not be construed as excluding a plurality. The use of reference signs in the claims with respect to elements indicated in the figures shall also not be construed as limiting the scope of the invention.

## Claims

1. A cabinet (1) for an ozone generator, said cabinet comprising:
- an enclosure (2) for containing an ozone generator, wherein said enclosure comprises walls surrounding said ozone generator and at least one opening;
- a hatch (3) for delimiting said enclosure;
- one or more grounding means for providing earth connection between said enclosure (2) and said hatch (3); wherein said one or more grounding means comprise at least:
• an elastic system (5) fastened to at least two of said walls surrounding said ozone generator; wherein said elastic system comprises at least an elastic element (4) suspended in a holder element (9) and wherein said elastic element is or comprise a metal helical coil spring (4), and wherein said holder element is or comprise a spring bracket (9) holding said metal helical coil spring (4);
• an elongated element (6) having a first end (7) and a second opposite end (8); said first end being fastened to said hatch, such as to an internal surface of said hatch, said second end configured to interfere with said elastic system; and wherein said second end is configured to interfere with said metal helical coil spring in a direction substantially orthogonal to a metal helical coil spring axis, wherein said metal helical coil spring axis is the metal helical coil spring compression axis.

2. A cabinet according to claim 1, wherein said enclosure (2) contains said ozone generator.

3. A cabinet according to any of the preceding claims 1-2, wherein said elastic system is a spring system (5).

4. A cabinet according to any of the preceding claims 1-3, wherein said elongated element is an elongated cylindrical body (6), such as a pin.

5. A cabinet according to any of the preceding claims 1-4, wherein said one or more grounding means are at least two grounding means located not more than 0.5 m in between each other.

6. An ozone generator apparatus comprising said cabinet according to any of the preceding claims 1-5.

7. A method for providing grounding and electromagnetic shielding to a cabinet containing an ozone generator according to any of the preceding claims 1-5, said method comprising:
- closing said hatch, thereby allowing for said elongated element to interfere with said elastic system.

8. A method for providing grounding and electromagnetic shielding to a cabinet containing an ozone generator, said cabinet comprising:
- an enclosure (2) for containing an ozone generator, wherein said enclosure comprises walls surrounding said ozone generator and at least one opening;
- a hatch (3) for delimiting said enclosure;
- one or more grounding means for providing earth connection between said enclosure (2) and said hatch (3); wherein said one or more grounding means comprise at least:
• an elastic system (5) fasten to at least two of said walls surrounding said ozone generator; wherein said elastic system comprises at least an elastic element (4) suspended in a holder element (9) and wherein said elastic element is or comprise a metal helical coil spring (4), and wherein said holder element is or comprise a spring bracket (9) holding said metal helical coil spring (4);
• an elongated element (6) having a first end (7) and a second opposite end (8); said first end being fastened to said hatch, such as to an internal surface of said hatch, said second end configured to interfere with said elastic system; and wherein said second end is configured to interfere with said metal helical coil spring in a direction substantially orthogonal to a metal helical coil spring axis, wherein said metal helical coil spring axis is the metal helical coil spring compression axis;
said method comprising:
- closing said hatch, thereby allowing for said elongated element to interfere with said elastic system.

9. A method according to claim 8, wherein said enclosure (2) contains said ozone generator.

10. A method according to any of the preceding claims 8-9, wherein said elastic system is a spring system (5).

11. A method according to any of the preceding claims 8-10, wherein said elongated element is an elongated cylindrical body (6), such as a pin.

12. A method according to any of the preceding claims 8-11, wherein said one or more grounding means are at least two grounding means located not more than 0.5 m in between each other.

## Patentansprüche

1. Schrank (1) für einen Ozongenerator, wobei der Schrank Folgendes umfasst:
- ein Gehäuse (2) zur Aufnahme eines Ozongenerators, wobei das Gehäuse Wände, die den Ozongenerator umgeben, und mindestens eine Öffnung umfasst,
- eine Klappe (3) zur Begrenzung des Gehäuses;
- ein oder mehrere Erdungsmittel zum Bereitstellen einer Erdverbindung zwischen dem Gehäuse (2) und der Klappe (3); wobei das eine oder die mehreren Erdungsmittel mindestens Folgendes umfassen:
• ein elastisches System (5), das an mindestens zwei der den Ozongenerator umgebenden Wände befestigt ist; wobei das elastische System mindestens ein elastisches Element (4) umfasst, das in einem Halteelement (9) aufgehängt ist, und wobei das elastische Element eine metallische spiralförmige Schraubenfeder (4) ist oder umfasst, und wobei das Halteelement eine Federhalterung (9) ist oder umfasst, die die metallische spiralförmige Schraubenfeder (4) hält;
• ein längliches Element (6) mit einem ersten Ende (7) und einem zweiten, gegenüberliegenden Ende (8); wobei das erste Ende an der Klappe, beispielsweise an einer Innenfläche der Klappe, befestigt ist, wobei das zweite Ende so konfiguriert ist, dass es mit dem elastischen System zusammenwirkt, und wobei das zweite Ende so konfiguriert ist, dass es mit der metallischen spiralförmigen Schraubenfeder in einer Richtung zusammenwirkt, die im Wesentlichen orthogonal zu einer Achse der metallischen spiralförmigen Schraubenfeder ist, wobei die Achse der metallischen spiralförmigen Schraubenfeder die Kompressionsachse der metallischen spiralförmigen Schraubenfeder ist.

2. Schrank nach Anspruch 1, wobei das Gehäuse (2) den Ozongenerator enthält.

3. Schrank nach einem der voranstehenden Ansprüche 1-2, wobei das elastische System ein Federsystem (5) ist.

4. Schrank nach einem der voranstehenden Ansprüche 1-3, wobei das längliche Element ein länglicher zylindrischer Körper (6), wie beispielsweise ein Stift, ist.

5. Schrank nach einem der voranstehenden Ansprüche 1-4, wobei das eine oder die mehreren Erdungsmittel mindestens zwei Erdungsmittel sind, die nicht mehr als 0,5 m voneinander entfernt sind.

6. Ozongeneratorgerät umfassend den Schrank nach einem der voranstehenden Ansprüche 1-5.

7. Verfahren zur Erdung und elektromagnetischen Abschirmung eines Schranks, der einen Ozongenerator nach einem der vorstehenden Ansprüche 1-5 enthält, wobei das Verfahren Folgendes umfasst:
- Schließen der Klappe, wodurch das längliche Element in das elastische System eingreifen kann.

8. Verfahren zur Bereitstellung einer Erdung und elektromagnetischen Abschirmung eines Schranks, der einen Ozongenerator enthält, wobei der Schrank Folgendes umfasst:
- ein Gehäuse (2) zur Aufnahme eines Ozongenerators, wobei das Gehäuse Wände, die den Ozongenerator umgeben, und mindestens eine Öffnung umfasst,
- eine Klappe (3) zur Begrenzung des Gehäuses;
- ein oder mehrere Erdungsmittel zum Bereitstellen einer Erdverbindung zwischen dem Gehäuse (2) und der Klappe (3); wobei das eine oder die mehreren Erdungsmittel mindestens Folgendes umfassen:
• ein elastisches System (5), das an mindestens zwei der den Ozongenerator umgebenden Wände befestigt ist; wobei das elastische System mindestens ein elastisches Element (4) umfasst, das in einem Halteelement (9) aufgehängt ist, und wobei das elastische Element eine metallische spiralförmige Schraubenfeder (4) ist oder umfasst, und wobei das Halteelement eine Federhalterung (9) ist oder umfasst, die die metallische spiralförmige Schraubenfeder (4) hält;
• ein längliches Element (6) mit einem ersten Ende (7) und einem zweiten, gegenüberliegenden Ende (8); wobei das erste Ende an der Klappe, beispielsweise an einer Innenfläche der Klappe, befestigt ist, wobei das zweite Ende so konfiguriert ist, dass es mit dem elastischen System zusammenwirkt, und wobei das zweite Ende so konfiguriert ist, dass es mit der metallischen spiralförmigen Schraubenfeder in einer Richtung zusammenwirkt, die im Wesentlichen orthogonal zu einer Achse der metallischen spiralförmigen Schraubenfeder ist, wobei die Achse der metallischen spiralförmigen Schraubenfeder die Kompressionsachse der metallischen spiralförmigen Schraubenfeder ist;
wobei das Verfahren Folgendes umfasst:
- Schließen der Klappe, wodurch das längliche Element in das elastische System eingreifen kann.

9. Verfahren nach Anspruch 8, wobei das Gehäuse (2) den Ozongenerator enthält.

10. Verfahren nach einem der voranstehenden Ansprüche 8-9, wobei das elastische System ein Federsystem (5) ist.

11. Verfahren nach einem der voranstehenden Ansprüche 8-10, wobei das längliche Element ein länglicher zylindrischer Körper (6), wie beispielsweise ein Stift, ist.

12. Verfahren nach einem der voranstehenden Ansprüche 8-11, wobei das eine oder die mehreren Erdungsmittel mindestens zwei Erdungsmittel sind, die nicht mehr als 0,5 m voneinander entfernt sind.

## Revendications

1. Armoire (1) pour un générateur d'ozone, ladite armoire comprenant :
- une enceinte (2) destinée à contenir un générateur d'ozone, dans laquelle ladite enceinte comprend des parois entourant ledit générateur d'ozone et au moins une ouverture ;
- un panneau (3) pour délimiter ladite enceinte ;
- un ou plusieurs moyens de mise à la terre pour fournir une connexion à la terre entre ladite enceinte (2) et ledit panneau (3) ; dans laquelle ledit ou lesdits moyens de mise à la terre comprennent au moins :
• un système élastique (5) fixé à au moins deux desdites parois entourant ledit générateur d'ozone ; dans laquelle ledit système élastique comprend au moins un élément élastique (4) suspendu dans un élément de support (9) et dans laquelle ledit élément élastique est ou comprend un ressort hélicoïdal métallique (4), et dans laquelle ledit élément de support est ou comprend un support de ressort (9) maintenant ledit ressort hélicoïdal métallique (4) ;
• un élément allongé (6) ayant une première extrémité (7) et une seconde extrémité opposée (8) ; ladite première extrémité étant fixée audit panneau, par exemple à une surface interne dudit panneau, ladite seconde extrémité étant configurée pour interférer avec ledit système élastique ; et dans laquelle la seconde extrémité est conçue pour interférer avec le ressort hélicoïdal métallique dans une direction sensiblement orthogonale un axe du ressort hélicoïdal métallique, dans laquelle l'axe du ressort hélicoïdal métallique est l'axe de compression du ressort hélicoïdal métallique.

2. Armoire selon la revendication 1, dans laquelle l'enceinte (2) contient le générateur d'ozone.

3. Armoire selon l'une des revendications précédentes 1 à 2, dans laquelle le système élastique est un système à ressort (5).

4. Armoire selon l'une des revendications précédentes 1 à 3, dans laquelle l'élément allongé est un corps cylindrique allongé (6), tel qu'une goupille.

5. Armoire selon l'une des revendications précédentes 1 à 4, dans laquelle ledit ou lesdits moyens de mise à la terre sont au moins deux moyens de mise à la terre situés à une distance maximale de 0,5 m l'un de l'autre.

6. Appareil générateur d'ozone comprenant ladite armoire selon l'une quelconque des revendications précédentes 1 à 5.

7. Procédé destiné à fournir une mise à la terre et un blindage électromagnétique à une armoire contenant un générateur d'ozone selon l'une quelconque des revendications précédentes 1 à 5, ledit procédé comprenant :
- la fermeture dudit panneau, permettant ainsi audit élément allongé d'interférer avec ledit système élastique.

8. Procédé destiné à fournir une mise à la terre et un blindage électromagnétique à une armoire contenant un générateur d'ozone, ladite armoire comprenant :
- une enceinte (2) destinée à contenir un générateur d'ozone, dans lequel ladite enceinte comprend des parois entourant ledit générateur d'ozone et au moins une ouverture ;
- un panneau (3) pour délimiter ladite enceinte ;
- un ou plusieurs moyens de mise à la terre pour fournir une connexion à la terre entre ladite enceinte (2) et ledit panneau (3) ; dans lequel ledit ou lesdits moyens de mise à la terre comprennent au moins :
• un système élastique (5) fixé à au moins deux desdites parois entourant ledit générateur d'ozone ; dans lequel ledit système élastique comprend au moins un élément élastique (4) suspendu dans un élément de support (9) et dans lequel ledit élément élastique est ou comprend un ressort hélicoïdal métallique (4), et dans lequel ledit élément de support est ou comprend un support de ressort (9) maintenant ledit ressort hélicoïdal métallique (4) ;
• un élément allongé (6) ayant une première extrémité (7) et une seconde extrémité opposée (8) ; ladite première extrémité étant fixée audit panneau, par exemple à une surface interne dudit panneau, ladite seconde extrémité étant configurée pour interférer avec ledit système élastique ; et dans lequel la seconde extrémité est conçue pour interférer avec le ressort hélicoïdal métallique dans une direction sensiblement orthogonale un axe du ressort hélicoïdal métallique, dans lequel l'axe du ressort hélicoïdal métallique est l'axe de compression du ressort hélicoïdal ;
ledit procédé comprenant :
- la fermeture dudit panneau, permettant ainsi audit élément allongé d'interférer avec ledit système élastique.

9. Procédé selon la revendication 8, dans lequel ladite enceinte (2) contient ledit générateur d'ozone.

10. Procédé selon l'une quelconque des revendications précédentes 8 et 9, dans lequel ledit système élastique est un système à ressort (5).

11. Procédé selon l'une quelconque des revendications précédentes 8 à 10, dans lequel ledit élément allongé est un corps cylindrique allongé (6), tel qu'une goupille.

12. Procédé selon l'une quelconque des revendications précédentes 8 à 11, dans lequel ledit ou lesdits moyens de mise à la terre sont au moins deux moyens de mise à la terre situés à une distance maximale de 0,5 m l'un de l'autre.
